# EUROPEAN PATENT APPLICATION

(11) **EP 4 195 305 A1**
(43) Date of publication of application: **14.06.2023**
(21) Application number: 21865912.6
(22) Date of filing: 02.09.2021
(51) Int. Cl.: H01L 51/52, H01L 51/56, H01L 27/32, G09F 9/30

(54) **DISPLAY SCREEN AND MANUFACTURING METHOD THEREFOR, AND DISPLAY TERMINAL**

(30) Priority: 09.09.2020 CN 202010942459; 21.01.2021 CN 202110082424
(71) Applicant: Huawei Technologies Co., Ltd., Shenzhen, Guangdong 518129 (CN)
(72) Inventor: LONG, Haohui, Shenzhen, Guangdong 518129 (CN); ZHOU, Yang, Shenzhen, Guangdong 518129 (CN)
(74) Representative: Pfenning, Meinig & Partner mbB
(86) International application number: PCT/CN2021/116213
(87) International publication number: WO 2022/052858

(57) **Abstract**

Embodiments of this application provide a display screen, a method for manufacturing the display screen, and a display terminal, and relate to the field of display technologies, to resolve a device failure of a light emitting device caused by water and oxygen invasion in a process of bending a flexible display screen. The display screen includes a redistribution layer, a plurality of light emitting units, and a plurality of driver chips. The redistribution layer includes a flexible dielectric layer and a metal interconnection structure disposed in the flexible dielectric layer. The light emitting unit includes at least one light emitting chip. The light emitting diode is disposed on the redistribution layer. A pad of the light emitting chip is bonded to the metal interconnection structure. The plurality of driver chips are disposed on the redistribution layer. A pad of the driver chip is bonded to the metal interconnection structure. One driver chip is electrically connected to light emitting chips in the same light emitting unit by using metal interconnection structure, and the driver chip is configured to drive the light emitting chip to emit light.

## Description

This application claims priority to Chinese Patent Application No. 202010942459.9, filed with the China National Intellectual Property Administration on September 9, 2020 and entitled "DISPLAY MODULE, DISPLAY PANEL, AND ELECTRONIC DEVICE", and Chinese Patent Application No. 202110082424.7, filed with the China National Intellectual Property Administration on January 21, 2021 and entitled "DISPLAY SCREEN, METHOD FOR MANUFACTURING SAME, AND DISPLAY TERMINAL", both of which are incorporated herein by reference in their entireties.

### TECHNICAL FIELD

This application relates to the field of display technologies, and in particular, to a display screen, a method for manufacturing the display screen, and a display terminal.

### BACKGROUND

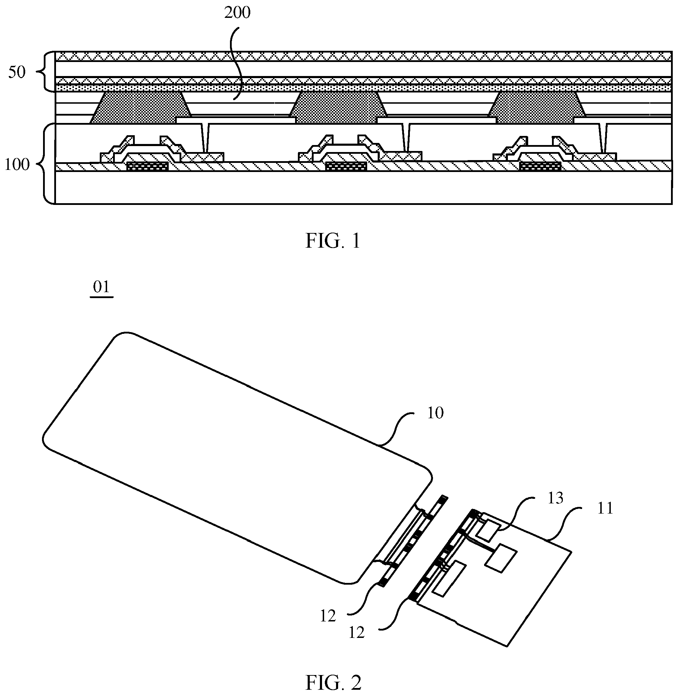

Currently, to achieve a bendable screen, an AMOLED flexible display screen can be manufactured on a substrate made of a flexible material by using an active matrix organic light emitting diode (active matrix organic light emitting diode, AMOLED) technology. The AMOLED flexible display screen may include a flexible thin film transistor (thin film transistor, TFT) substrate 100 shown in FIG. 1, and a plurality of OLED light emitting devices 200 arranged in an array on the flexible TFT substrate 100. To avoid a problem that the OLED light emitting device 200 cannot emit light because water and oxygen enter an organic material in the OLED light emitting device 200, the AMOLED flexible display screen may further include a packaging layer 50 having an inorganic material. However, in a process of bending the flexible display screen, the foregoing inorganic material is prone to crack or delamination. Consequently, water and oxygen enter the OLED light emitting device, and a device failure occurs.

### SUMMARY

This application provides a display screen, a method for manufacturing the display screen, and a display terminal, to resolve a device failure of a light emitting device caused by water and oxygen invasion in a process of bending a flexible display screen.

To achieve the foregoing objective, the following technical solutions are used in this application.

According to one aspect of this application, a display screen is provided. The display screen includes a redistribution layer, a plurality of light emitting units, and a plurality of driver chips. The redistribution layer includes a flexible dielectric layer and a metal interconnection structure disposed in the flexible dielectric layer. The light emitting unit includes at least one light emitting chip. The light emitting chip is disposed on the redistribution layer. A pad of the light emitting chip is bonded to the metal interconnection structure. The plurality of driver chips are disposed on the redistribution layer, and a pad of the driver chip is bonded to the metal interconnection structure. One driver chip is electrically connected to the light emitting chip in the same light emitting unit by using the metal interconnection structure, and the driver chip is configured to drive the light emitting chip to emit light. In conclusion, the display screen provided in this embodiment of this application uses the light emitting chip to display an image. The light emitting chip is a micro LED or a mini LED made of an inorganic material and has low sensitivity to water and oxygen, and therefore is not easily eroded by water and oxygen. In this case, an inorganic layer material that easily breaks in a bending process is not used as the packaging layer. The light emitting chip may be simply packaged by using a polymer material with good elasticity and high transparency. This improves bending reliability of the flexible display screen. Further, a discrete array of the plurality of light emitting chips is distributed on the redistribution layer. In a process of stretching and bending the display screen, a pulling force between the plurality of light emitting devices can be reduced. Therefore, compared with an AMOLED display screen whose light emitting devices are continuously distributed on an inorganic layer, the display screen has better bendability and elasticity. In addition, the redistribution layer of the display screen provided in this embodiment of this application includes a flexible dielectric layer and at least one metal pattern layer embedded into the flexible dielectric layer. The metal pattern layer may include a plurality of first metal wires. The first metal wire may be manufactured by using metal material copper. Because the metal copper has specific ductility, elasticity and bendability of the redistribution layer can be further improved.

Optionally, the redistribution layer includes a first surface. Both the light emitting chip and the driver chip are disposed on the first surface. The metal interconnection structure includes a metal pattern layer. A side that is of the metal pattern layer and that is away from the light emitting chip is in contact with the flexible dielectric layer. The metal pattern layer includes a plurality of first metal wires. One end of the first metal wire is bonded to the pad of the light emitting chip. The other end of the first metal wire is bonded to the pad of the driver chip. In this way, the light emitting chip is electrically connected to the driver chip through the first metal wire.

Optionally, the redistribution layer includes a first surface and a second surface, and the first surface and the second surface are opposite to each other. The light emitting chip is disposed on the first surface, and the driver chip is disposed on the second surface. The metal interconnection structure includes a metal through via that penetrates the flexible dielectric layer. One end of the metal through via is bonded to the pad of the light emitting chip, and the other end of the metal through via is bonded to the pad of the driver chip. In this way, the light emitting chip is electrically connected to the driver chip by using the metal through via.

Optionally, a material of the metal interconnection structure is the same as a material of the pad of the light emitting chip and a material of the pad of the driver chip. In this way, in a process of bonding the metal interconnection structure to the pad of the light emitting chip and the pad of the driver chip through metal bonding, bonding strength of a bonding structure can be improved.

Optionally, the display screen has a first area and a second area located around the first area. The light emitting unit and the driver chip are located in the first area. The display screen further includes a plurality of first bonding pins disposed in the second area. The metal interconnection structure includes a metal pattern layer. A side that is of the metal pattern layer and that is away from the light emitting chip is in contact with the flexible dielectric layer. The metal pattern layer includes a plurality of second metal wires. One end of the second metal wire is electrically connected to the pad of the driver chip, and the other end of the second metal wire is electrically connected to the first bonding pin. In this way, the driver chip may be electrically connected to the diode on the circuit board through the second metal wire and the first bonding pin.

Optionally, the display screen further includes a sensor, and the sensor includes a sensor chip. The sensor chip is disposed on the redistribution layer. A pad of the sensor chip is electrically connected to the metal interconnection structure. In this way, integration of the display screen can be improved through sensor integration in the display screen.

Optionally, the sensor chip and the light emitting chip are located on a same side, and are disposed between two adjacent light emitting chips. In this way, the sensor does not need to be disposed in an independent area, and an effective display area of the display screen can be increased.

Optionally, the display screen has the first area and the second area located around the first area. The light emitting unit and the driver chip are located in the first area. The display screen further includes a plurality of second bonding pins disposed in the second area. The metal interconnection structure includes the metal pattern layer. A side that is of the metal pattern layer and that is away from the light emitting chip is in contact with the flexible dielectric layer. The metal pattern layer includes a plurality of third metal wires. One end of the third metal wire is electrically connected to the pad of the sensor chip, and the other end of the third metal wire is electrically connected to the second bonding pin. In this way, the sensor chip may be electrically connected to the diode on the circuit board through the third metal wire and the second bonding pin.

Optionally, the at least one light emitting chip in the same light emitting unit includes a first light emitting chip, a second light emitting chip, and a third light emitting chip. The first light emitting chip, the second light emitting chip, and the third light emitting chip respectively are configured to emit trichromatic light. One driver chip is electrically connected to the first light emitting chip, the second light emitting chip, and the third light emitting chip in the same light emitting unit. In this way, at different stages in an image frame, the driver chip may control different light emitting chips in a same light emitting unit to emit light, so that a color displayed by the light emitting unit is a color obtained through mixing lights sequentially emitted by the plurality of light emitting chips in the light emitting unit in the image frame.

Optionally, the display screen has the first area and the second area located around the first area. The light emitting unit and the driver chip are located in the first area. The display screen further includes a flexible and stretchable layer. The flexible and stretchable layer is disposed in the second area in a stretching direction of the display screen, and is connected to a surface of a side that is of the redistribution layer and that is away from the light emitting unit.

Optionally, the display screen further includes a packaging layer. The packaging layer is located on a side that is of the light emitting chip and that is away from the redistribution layer, and covering the light emitting chip and the redistribution layer. Closed space for accommodating the light emitting chip may be formed between the packaging layer and the redistribution layer, so that the light emitting chip can be isolated from an external environment of the display screen.

Optionally, a material of the packaging layer includes silica gel. The silica gel has good elasticity, and after the light emitting chip is packaged, elasticity and bendability of the display screen can be further improved. In addition, the silica gel has high transparency, and therefore definition of an image displayed on the display screen is not affected.

Optionally, a material of the flexible dielectric layer includes polyimide. Polyimide has good flexibility, and can effectively improve bendability and elasticity of the display screen.

Another aspect of this application provides a display terminal. The display terminal includes a circuit board and any display screen described above. The circuit board is electrically connected to the metal interconnection structure in the redistribution layer. The display terminal has the same technical effect as that of the display screen provided in the foregoing embodiment, and details are not described herein again.

Optionally, the display screen has a first area and a second area located around the first area. A light emitting unit and a driver chip are located in the first area. The display screen further includes a flexible and stretchable layer. The flexible and stretchable layer is disposed in the second area in a stretching direction of the display screen, and is connected to a surface of a side that is of the redistribution layer and that is away from the light emitting unit. The display terminal further includes a reel. A part of the redistribution layer and a part of a flexible and stretchable layer are wound around the reel. The reel is connected to an end that is of the redistribution layer and wound around the reel and an end that is of the flexible and stretchable layer and wound around the reel. A technical effect of the flexible and stretchable layer is the same as that described above, and details are not described herein again. In addition, because one end that is of the redistribution layer and wound around the reel and one end that is of the flexible and stretchable layer and wound around the reel are connected to the reel, after the display screen is completely stretched, one end of the display screen may be fastened to the reel by using the redistribution layer and the flexible and stretchable layer.

Optionally, the circuit board is a flexible circuit board. In this case, the display terminal is a flexible display terminal.

According to still another aspect of this application, a method for manufacturing a display screen is provided. The method includes: pasting a plurality of light emitting chips and a plurality of driver chips to a carrying surface of a carrier board, where a pad of the light emitting chip and a pad of the driver chip are far away from the carrying surface of the carrier board; forming a plurality of first metal wires on the carrier board on which the light emitting chip and the driver chip are disposed, bonding one end of the first metal wire to the pad of the light emitting chip, and bonding the other end of the first metal wire to the pad of the driver chip; forming a flexible dielectric layer on a surface of a side that is of the first metal wire and that is away from the carrier board; and removing the carrier board. The method for manufacturing a display screen has the same technical effect as that of the display screen provided in the foregoing embodiment, and details are not described herein again.

Optionally, the method further includes: forming, on a surface of a side that is of plurality of light emitting chips and the plurality of driver chips and that is away from the flexible dielectric layer, a packaging layer that covers the plurality of light emitting chips, the plurality of driver chips, and the flexible dielectric layer. A technical effect of the packaging layer is the same as that described above, and details are not described herein again.

According to yet another aspect of this application, a method for manufacturing a display screen is provided. The manufacturing method includes: pasting a plurality of driver chips to a carrying surface of a carrier board, where a pad of the driver chip is far away from the carrying surface of the carrier board; forming a flexible dielectric layer on the carrier board on which the driver chip is disposed; forming a plurality of metal through vias that penetrate the flexible dielectric layer, where one end of the metal through via is bonded to the pad of the driver chip; disposing a plurality of light emitting chips on a surface of a side that is of the flexible dielectric layer and that is away from the driver chip, where a pad of the light emitting chip is connected to the other end of the metal through via, so that one driver chip is electrically connected to at least one light emitting chip; and removing the carrier board. The method for manufacturing a display screen has the same technical effect as that of the display screen provided in the foregoing embodiment, and details are not described herein again.

Optionally, the method further includes: forming, on a surface of a side that is of the plurality of light emitting chips and that is away from the flexible dielectric layer, a packaging layer that covers the plurality of light emitting chips and the flexible dielectric layer. A technical effect of the packaging layer is the same as that described above, and details are not described herein again.

### BRIEF DESCRIPTION OF DRAWINGS

FIG. 1 is a schematic diagram of a structure of a display screen according to a conventional technology;
FIG. 2 is a schematic diagram of a structure of a display terminal according to an embodiment of this application;
FIG. 3A is a schematic diagram of a structure of a display screen in FIG. 2;
FIG. 3B is another schematic diagram of a structure of a display screen in FIG. 2;
FIG. 3C is a schematic diagram of a structure of a minimum repetition unit in a display screen in FIG. 3B;
FIG. 4A is another schematic diagram of a structure of a display screen in FIG. 2;
FIG. 4B is a schematic top view of a structure of a metal pattern layer in FIG. 4A;
FIG. 5 is a flowchart of a method for manufacturing a display screen according to an embodiment of this application;
FIG. 6, FIG. 7, FIG. 8, FIG. 9, and FIG. 10 are schematic diagrams of structures obtained when steps in FIG. 5 are performed;
FIG. 11 is a schematic diagram of a structure of a display screen according to an embodiment of this application;
FIG. 12 is a schematic diagram of another structure of a display terminal according to an embodiment of this application;
FIG. 13A is a schematic diagram of another structure of a display terminal according to an embodiment of this application;
FIG. 13B is a schematic diagram of another structure of a display screen according to an embodiment of this application;
FIG. 14 is a schematic diagram of another structure of a display screen according to an embodiment of this application;
FIG. 15 is a flowchart of another method for manufacturing a display screen according to an embodiment of this application;
FIG. 16, FIG. 17, FIG. 18, and FIG. 19 are schematic diagrams of structures obtained when steps in FIG. 15 are performed;
FIG. 20 is a schematic diagram of a process of manufacturing a display screen according to an embodiment of this application;
FIG. 21 is a schematic diagram of another structure of a display screen according to an embodiment of this application;
FIG. 22A is a schematic diagram of another structure of a display terminal according to an embodiment of this application;
FIG. 22B is a schematic diagram of another structure of a display terminal according to an embodiment of this application; and
FIG. 23 is a schematic diagram of another structure of a display terminal according to an embodiment of this application.

### Reference numerals:

100-TFT substrate; 200-OLED light emitting device; 50-packaging layer; 01-display terminal; 10-display screen; 11-circuit board; 12-bonding pin; 13-data processing chip; 20-redistribution layer; 30-light emitting unit; 40-driver chip; 301-light emitting chip; 301a-first light emitting chip; 301b-second light emitting chip; 301c-third light emitting chip; 400-minimum repetition unit; 22-metal pattern layer; 201-flexible dielectric layer; 202-metal interconnection structure; 221-first metal wire; 31-pad of a light emitting chip; 41-pad of a driver chip; 500-carrier board; 501-first thermal release adhesive; 502-second thermal release adhesive; 600-first area; 601-second area; 24-second metal wire; 25-third metal wire; 60-sensor; 61-sensor chip; 62-pad of a sensor chip; 70-flexible and stretchable layer; 71-reel; 72-positioning component; 80-housing; 81-guide groove.

### DESCRIPTION OF EMBODIMENTS

The following describes technical solutions in embodiments of this application with reference to the drawings in embodiments of this application. It is clear that the described embodiments are merely a part rather than all of embodiments of this application.

Terms such as "first" and "second" mentioned below are merely used for description, and shall not be understood as an indication or implication of relative importance or implicit indication of a quantity of indicated technical features. Therefore, a feature limited by "first" or "second" may explicitly or implicitly include one or more features.

In addition, in this application, orientation terms such as "above" and "below" may include but are not limited to orientations of schematically placed components in relative accompanying drawings. It should be understood that these orientation terms may be relative concepts. The orientation terms are used for relative description and clarification, and may vary correspondingly based on a change in an orientation in which the component is placed in the accompanying drawings.

In this application, it should be noted that the term "connection" should be understood in a broad sense unless otherwise expressly specified and limited. For example, the "connection" may be fixed connection, releasable connection, or integration, or may be direct connection, or may be indirect connection implemented through a medium. In addition, the term "electrical connection" may be direct electrical connection, or may be indirect electrical connection implemented through a medium.

This embodiment of this application provides a display terminal. The display terminal may include an electronic product having a display function, such as a mobile phone (mobile phone), a tablet computer (pad), a television, an intelligent wearable product (for example, a smartwatch or a smart band), a virtual reality (virtual reality, VR) terminal device, or an augmented reality (augmented reality, AR) terminal device. A specific form of the display terminal is not specially limited in this embodiment of this application.

For example, the display terminal is a mobile phone. A display terminal 01 may include a display screen 10 and a circuit board 11 shown in FIG. 2. When the display terminal 01 is a flexible display terminal, the display screen 10 may be a flexible display screen, and the circuit board 11 may be a flexible printed circuit (flexible printed circuit, FPC). A bonding (bonding) pin (pin) 12 is disposed on each of the display screen 10 and the circuit board 11, so that the display screen 10 and the circuit board 11 may be electrically connected through the bonding pins 12.

In addition, a plurality of data processing chips 13 may be disposed on the circuit board 11, for example, a system on a chip (system on a chip, SOC), a central processing unit (central processing unit, CPU), or a graphics processing unit (graphics processing unit, GPU). When the display screen 10 and the circuit board 11 are electrically connected through the foregoing bonding pins 12, the foregoing chip may transmit data to the display screen 10 through a circuit structure in the circuit board 11, to control the display screen 10 to display an image. In addition, a plurality of storage chips may be disposed on the circuit board 11, for example, a universal flash storage (universal flash storage, LTFS) or a double data rate (double data rate, DDR) memory, and are configured to store data.

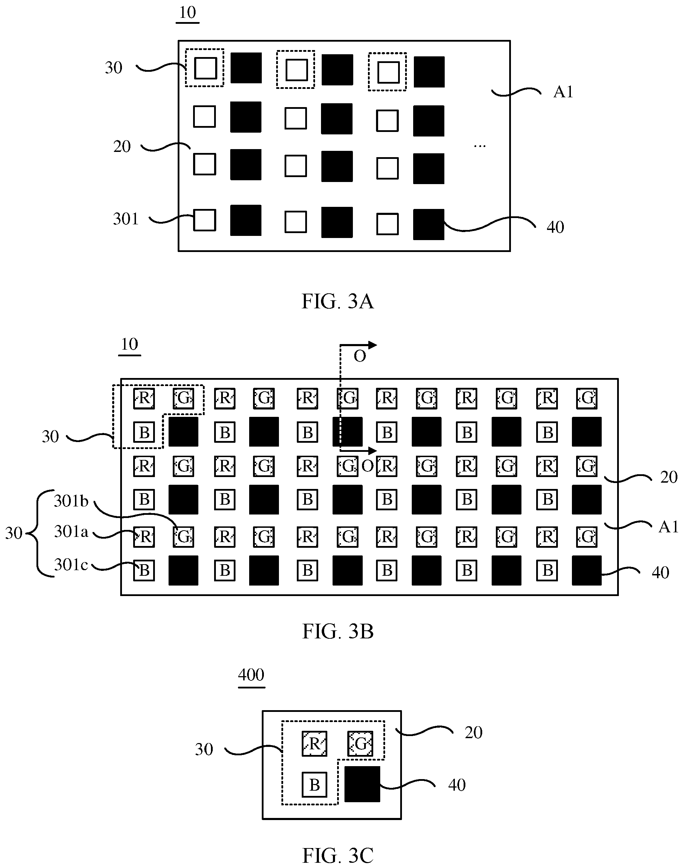

As shown in FIG. 3A, the display screen 10 may include a redistribution layer (redistribution layer, RDL) 20, a plurality of light emitting units 30, and a plurality of driver chips 40. The light emitting unit 30 may include at least one light emitting chip 301. For example, the light emitting chip 301 may be a micro (micro) light emitting diode (light emitting diode, LED) with a chip size of tens of micrometers (for example, an area less than 50 µm×50 µm), or a mini (mini) LED with a chip size of more than 100 micrometers. In some embodiments of this application, as shown in FIG. 3A, one light emitting unit 30 may include one light emitting device 301. In this case, one driver chip 40 may be electrically connected to one light emitting chip 301 through the redistribution layer 20, to drive the light emitting chip 301 to emit light.

Alternatively, in some other embodiments of this application, as shown in FIG. 3B, a light emitting unit 30 may include a first light emitting chip 301a, a second light emitting chip 301b, and a third light emitting chip 301c. The first light emitting chip 301a, the second light emitting chip 301b, and the third light emitting chip 301c may be separately configured to emit trichromatic light. The trichromatic light may be red (red, R), green (green, G), or blue (blue, B). For example, the first light emitting chip 301a is configured to emit R light, the second light emitting chip 301b is configured to emit G light, and the third light emitting chip 301c is configured to emit B light.

In this case, one driver chip 40 may be electrically connected to the first light emitting chip 301a, the second light emitting chip 301b, and the third light emitting chip 301c in the same light emitting unit 30 through the redistribution layer 20. In this way, one driver chip 40 and one light emitting unit 30 electrically connected to the driver chip 40 may form a minimum repetition unit 400 shown in FIG. 3C in the display screen 10. Minimum repetition units 400 may be arranged in an array on a first surface A1 of the redistribution layer 20.

Based on this, the driver chip 40 may separately control the first light emitting chip 301a, the second light emitting chip 301b, and the third light emitting chip 301c in the same light emitting unit 30. In this way, at different stages of an image frame, the driver chip 40 may control different light emitting chips in the same light emitting unit 30 to emit light, so that a color displayed by the light emitting unit 30 is a color obtained after mixing lights sequentially emitted by the plurality of light emitting chips in the light emitting unit 30 in the image frame. For example, the driver chip 40 drives the first light emitting chip 30 1a to emit R light at a first moment of an image frame, drives the second light emitting chip 301b to emit G light at a second moment, and controls the third light emitting chip 301c not to emit light at a third moment, so that the entire light emitting unit 30 can display, in the image frame, yellow obtained after the R light and the G light are mixed.

In addition, when the light emitting chip 301 is a micro LED or a mini LED, the light emitting chip 301 is a current driver. In this case, the driver chip 40 may further adjust a magnitude of a drive current provided to the light emitting chip 301, to control luminance of light emitted by the light emitting chip 301 and grayscale display of the light emitting unit 30.

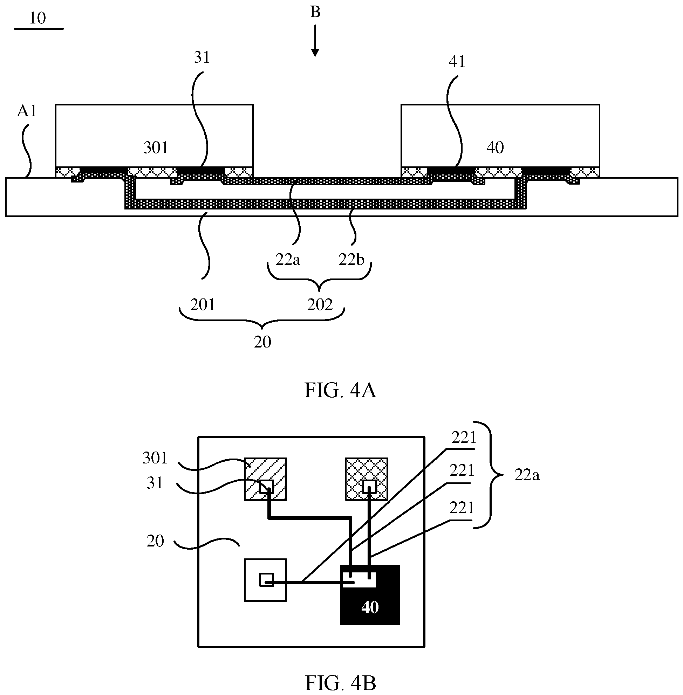

FIG. 3A and FIG. 3B are described by using an example in which both the light emitting unit 30 and the driver chip 40 are disposed on a same surface of the redistribution layer 20, for example, a first surface A1 of the redistribution layer 20. In this case, to enable the driver chip 40 to be electrically connected to the light emitting device 301 in the light emitting unit 30, as shown in FIG. 4A (a sectional view obtained by cutting along a dashed line O-O in FIG. 3B), the redistribution layer 20 may include a flexible dielectric layer 201 and a metal interconnection structure 202 disposed in the flexible dielectric layer 201.

A material of the flexible dielectric layer 201 may include a polymer flexible insulating material such as polyimide (polyimide, PI), poly-p-phenylene benzobisoxazole (poly-p-phenylene benzobisoxazole, PBO) fiber, benzocyclobutene (benzocyclobutene, BCB), or epoxy. This improves bendability and elasticity of the display screen 10. A material of the metal interconnection structure 202 may be a metal conductive material having good electrical conductivity, such as copper, aluminum, or silver.

For example, the metal interconnection structure 202 may include at least one metal pattern layer shown in FIG. 4A, for example, a metal pattern layer 22a and a metal pattern layer 22b. At least one side that is of the metal pattern layer and that is away from the light emitting chip 301 is in contact with the flexible dielectric layer 201. For example, a side that is of the metal pattern layer 22a and that is away from the light emitting chip 301 is in contact with the flexible dielectric layer 201. A side that is of the metal pattern layer 22b and that is closer to the light emitting chip 301 and a side of the light emitting chip 301 are in contact with the flexible dielectric layer 201.

The metal pattern layer 22a is used as an example. The metal pattern layer 22a may include a plurality of first metal wires 221 shown in FIG. 4B (a top view from a direction B in FIG. 4A). The metal interconnection structure 202 is bonded to the pad 31 of the light emitting chip 301 at one end of the first metal wire 221, and the metal interconnection structure 202 is bonded to the pad 41 of the driver chip 40 at the other end of the first metal wire 221. In this way, the driver chip 40 can be electrically connected to the driver chip 40 by using the metal interconnection structure 202 located at the redistribution layer 20.

It should be noted that FIG. 4A is described by using an example in which the metal interconnection structure 202 includes two metal pattern layers (the metal pattern layer 22a and the metal pattern layer 22b). In some other embodiments of this application, the metal interconnection structure 202 may include at least three metal pattern layers when pixel density of the display screen 10 is high, quantities of the driver chips 40 and the light emitting chips 301 are large, and a structure of the metal interconnection structure 202 is complex. Alternatively, the metal interconnection structure 202 may include one metal pattern layer when pixel density of the display screen 10 is low, quantities of the driver chips 40 and the light emitting chips 301 are small, and a structure of the metal interconnection structure 202 is simple.

"Same layer" in embodiments of this application refers to a film having a specific pattern that is formed in a same image composition processing, for example, an electroplating or photo etching process. For example, the plurality of first metal wires 221 shown in FIG. 4B in the metal pattern layer 22a (or the metal pattern layer 22b) may be formed in a same electroplating process. The first metal wire 221 in the metal pattern layer 22b and the first metal wire 221 in the metal pattern layer 22a are respectively formed in different electroplating processes. In addition, for different specific patterns, specific patterns in a formed layer-structure may be continuous or discontinuous, and these specific patterns may be at different heights or have different thicknesses.

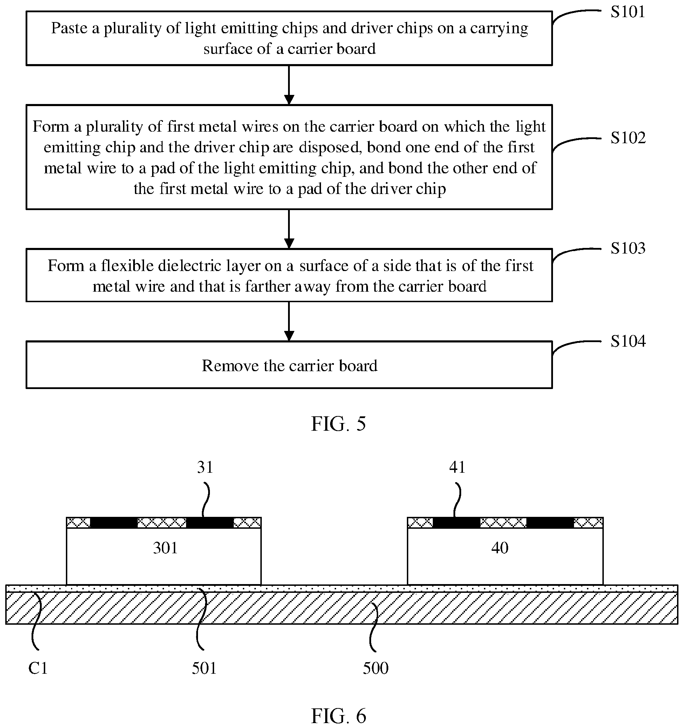

The structure shown in FIG. 4A may be manufactured by using a panel level package (panel level package, PLP) method. The method may include S101 to S104 shown in FIG. 5.

S101: Paste a plurality of light emitting chips 301 and driver chips 40 on a carrying surface C1 of a carrier board 500 as shown in FIG. 6.

For example, as shown in FIG. 6, light emitting surfaces of the plurality of light emitting chips 301 and passive surfaces of the plurality of driver chips 40 may be stuck on the carrying surface C1 of the carrier board 500 by using a first thermal release adhesive 501, to fix positions of the light emitting chips 301 and the driver chips 40. In this way, a pad 31 of the light emitting chip 301 and a pad 41 of the driver chip 40 may be disposed away from the carrying surface C1 of the carrier board 500, to facilitate electrical connection between the light emitting chip 301 and the driver chip 40 in a subsequent manufacturing process.

It should be noted that a surface on which the pad 41 is disposed in the driver chip 40 may be referred to as an active surface, and a surface opposite to the active surface in the driver chip 40 is a passive surface.

S102: Form a plurality of first metal wires 221 on the carrier board 500 on which the light emitting chips 301 and the driver chips 40 are disposed (as shown in FIG. 4B), where one end of the first metal wire 221 is bonded to the pad 31 of the light emitting chip 301, and the other end of the first metal wire 221 is bonded to the pad 41 of the driver chip 40.

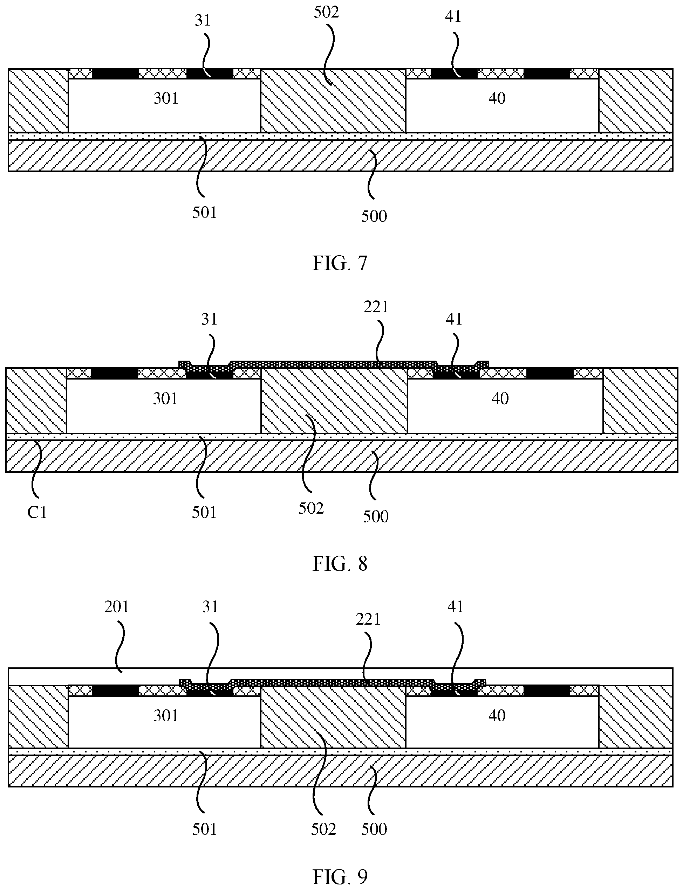

For example, because there is usually a gap between the light emitting chip 301 and the driver chip 40 that are fastened to the carrier board 500, before the first metal wire 221 is manufactured, a second thermal release adhesive 502 may be formed on the carrier board 500 on which the light emitting chip 301 and the driver chip 40 are disposed as shown in FIG. 7. The second thermal release adhesive 502 may be filled in the gap between the light emitting chip 301 and the driver chip 40, and the pad 31 of the light emitting chip 301 and the pad 41 of the driver chip 40 are exposed. Materials of the second thermal release adhesive 502 and the first thermal release adhesive 501 may be the same.

Through electroplating, the plurality of first metal wires 221 in FIG. 8 may be formed on a surface that is of the second thermal release adhesive 502 and that is away from the carrier board 500. The plurality of first metal wires 221 may form a metal pattern layer.

Through metal bonding, one end of the first metal wire 221 may be bonded to the pad 31 of the light emitting chip 301, and the other end of the first metal wire 221 may be bonded to the pad 41 of the driver chip 40, so that the light emitting chip 301 is electrically connected to the driver chip 40 by using the first metal wire 221. For example, when materials of the first metal wire 221, the pad 31 of the light emitting chip 301, and the pad 41 of the driver chip 40 are metal copper, the foregoing metal bonding process may be a copper-copper bonding process. In this case, because bonded metal materials are the same, bonding strength is improved.

S103. Form the flexible dielectric layer 201 on the surface of the side that is of the first metal wire 221 and that is away from the carrier board 500 as shown in FIG. 9.

For example, a polymer resin material, for example, the PI material, may be coated on the surface of the side that is of the first metal wire 221 and that is away from the carrier board 500, so that the formed flexible dielectric layer 201 can completely cover the first metal wire 221. Alternatively, a thin PI film may directly cover the surface of the side that is of the first metal wire 221 and that is away from the carrier board 500, to form the flexible dielectric layer 201.

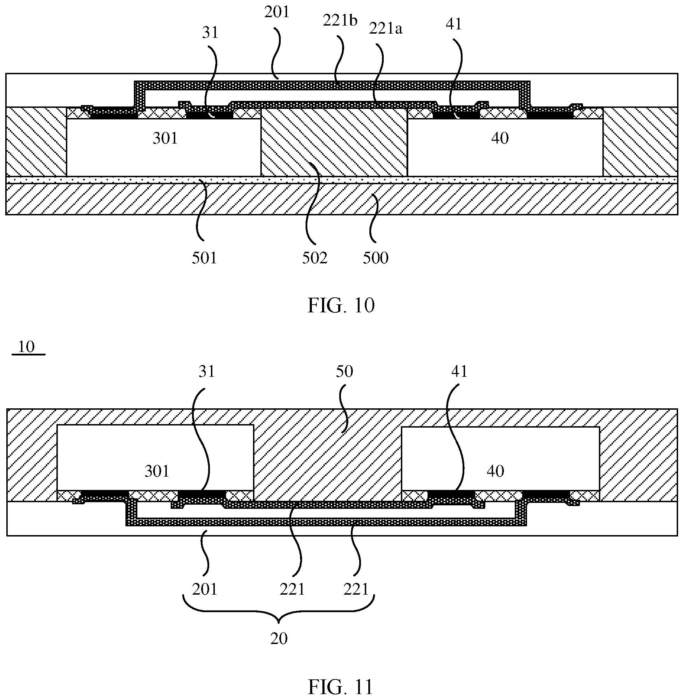

Based on a circuit structure of the metal interconnection structure 202, when another metal pattern layer needs to be added, a via (not shown in the figure) may be made on the flexible dielectric layer 201. The via may expose the pad 41 that is not electrically connected to the driver chip 40 and the pad 31 that is not electrically connected to the light emitting device 301. As shown in FIG. 10, through electroplating, a second layer of first-metal-trace layer 221b is formed on a surface of a side that is of the PI material covering a first layer of first-metal-trace layer 221a and that is away from the carrier board 500. A part of the material of the flexible dielectric layer 201 is between the second layer of first-metal-trace layer 221b and the first layer of first-metal-trace layer 221a. The PI material covers a surface of a side that is of the second layer of first-metal-trace layer 221b and that is away from the carrier board 500. The PI material is connected to the PI material covering the first layer of first-metal-trace layer 221a, to jointly form the flexible dielectric layer 201.

It should be noted that the foregoing descriptions are provided by using an example in which there are two layers of first metal wires. When the metal interconnection structure 202 has at least three first metal wires, a manufacturing method is the same as that described above, and details are not described herein again.

S104: Remove the carrier board 500.

For example, the first thermal release adhesive 501 and the second thermal release adhesive 502 in FIG. 10 may be heated to remove stickiness, to remove the first thermal release adhesive 501, the second thermal release adhesive 502, and the carrier board 500.

In addition, to package the light emitting chip 301, after S104 is performed, the method for manufacturing the display screen 10 may further include forming a packaging layer 50 on a side that is of the light emitting device 301 and that is away from the redistribution layer 20 as shown in FIG. 11. The packaging layer 50 may cover the light emitting chip 301 and the driver chip 40, and is connected to the redistribution layer 20.

It can be learned from the foregoing manufacturing process that the first metal wire 221 used to form the metal interconnection structure 202 at the redistribution layer 20 may be manufactured through electroplating, and the first metal wire 221 is bonded to the pad of the light emitting chip 301 and the pad of the driver chip 40 through metal bonding. Therefore, the foregoing redistribution layer 20 is directly formed above the light emitting chip 301 and the driver chip 40, and the light emitting chip 301 and the driver chip 40 may share the redistribution layer 20. As a result, an integration level of the display screen 10 can be improved.

A structure and a manufacturing process of the redistribution layer 20 are different from those of a flexible printed circuit (flexible printed circuit, FPC) or a printed circuit board (printed circuit board, PCB). However, the redistribution layer 20 has a metal interconnection structure 202 that can electrically connect the light emitting chip 301 to the driver chip 40. Therefore, there is no need to dispose a circuit board on a side that is of the redistribution layer 20 and that is away from the light emitting chip 301. In addition, a solder ball is not required between the redistribution layer 20 and the light emitting chip 301 or the driver chip 40. This simplifies a manufacturing process of the display screen 10 and a structure of the display screen 10.

In addition, as shown in FIG. 11, all metal wires used to electrically connect the light emitting chip 301 and the driver chip 40 are disposed in the redistribution layer 20 below the light emitting chip 301, so that the metal wires are not formed on (above) a light emitting surface of the light emitting chip 301. Therefore, in the solution provided in this embodiment of this application, the light emitting surface of the light emitting chip 301 is not blocked, thereby avoiding impact on brightness of light emitting by the display screen 10.

In addition, closed space used to accommodate the light emitting chip 301 and the driver chip 40 may be formed between the packaging layer 50 and the redistribution layer 20, so that the light emitting chip 301 can be isolated from an external environment of the display screen 10. In some embodiments of this application, a material of the packaging layer 50 may be a polymer material with good elasticity and high transparency, for example, silica gel. In this way, the light emitting chip 301 can be packaged to exclude water and oxygen, and bendability and elasticity of the display screen can be improved while definition of a picture displayed on the display screen is not greatly affected.

In conclusion, the display screen 10 provided in this embodiment of this application uses the light emitting chip 301 to display an image. The light emitting chip 301 is a micro LED or a mini LED made of an inorganic material and has low sensitivity to water and oxygen, and therefore is not easily eroded by water and oxygen. In this case, an inorganic layer material that easily breaks in a bending process is not used as the packaging layer. The light emitting chip 301 may be simply packaged by using a polymer material with good elasticity and high transparency. This improves bending reliability of the flexible display screen.

Further, a discrete array of a plurality of light emitting chips 301 is distributed on the redistribution layer 20. In a process of stretching and bending the display screen 10, a pulling force between the plurality of light emitting devices 301 can be reduced. Therefore, compared with an AMOLED display screen whose light emitting devices are continuously distributed on an inorganic layer, the display screen has better bendability and elasticity.

In addition, the redistribution layer 20 of the display screen 10 provided in this embodiment of this application includes the flexible dielectric layer 201 and at least one metal pattern layer embedded into the flexible dielectric layer 201. The metal pattern layer may include a plurality of first metal wires 221. The first metal wire 221 may be manufactured by using metal material copper. Because the metal copper has specific ductility, elasticity and bendability of the redistribution layer 20 can be further improved.

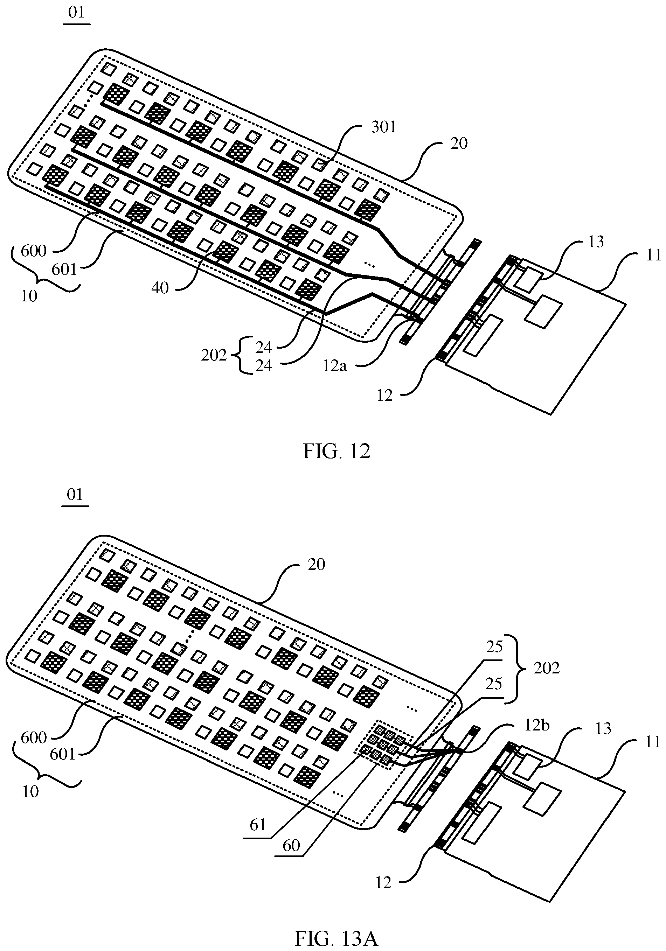

Based on this, as shown in FIG. 12, the display screen 10 has a first area 600 and a second area 601 located around the first area 600. Both the light emitting chip 301 and the driver chip 40 may be located in the first area 600.

Based on this, as shown in FIG. 12, the display screen 10 may further include a plurality of first bonding pins 12a disposed in the second area 601 to enable the data processing chip 13 and the storage chip on the circuit board 11 to be electrically connected to the driver chip 40 in the display screen 10, so that the driver chip 40 can drive, under control of the data processing chip 13, the light emitting chip 301 to emit light.

Based on this, the metal interconnection structure 202 in the redistribution layer 20 may further include a plurality of second metal wires 24. One end of the second metal wire 24 is electrically connected to the pad 41 of the driver chip 40 (as shown in FIG. 11), and the other end of the second metal wire 24 is electrically connected to the first bonding pin 21. The first bonding pin 12a may be welded to the bonding pin 12 of the circuit board 11, so that the driver chip 40 can be electrically connected to the data processing chip 13 and the storage chip on the circuit board 11 through the second metal wire 24.

For example, when the first metal wire 221 used to electrically connect the driver chip 40 and the light emitting chip 301 is manufactured in the foregoing electroplating process, the second metal wire 24 may be manufactured at the same time, and the second metal wire 24 and the first metal wire 221 are spaced, to ensure that the second metal wire 24 is insulated from the first metal wire 221. In this case, the first metal wire 221 and the second metal wire 24 are on a same metal pattern layer. Alternatively, the first metal wire 221 and the second metal wire 24 may be separately formed in two electroplating processes. In this case, the first metal wire 221 and the second metal wire 24 may be on different metal pattern layers.

In addition, the sensor 60 shown in FIG. 13A may be further integrated on a flexible substrate 20 of the display screen 10, and the sensor 60 may include at least one sensor chip 61. The sensor 30 may be a fingerprint sensor, a pressure sensor, a structured light sensor, a temperature sensor, or the like. When the sensor 60 includes a plurality of sensor chips 61, the plurality of sensor chips 61 may be distributed in a discrete array, and each sensor chip 61 may be used as a pixel of the sensor 60.

It should be noted that FIG. 13A is described by using an example in which all sensor chips 61 in the sensor 60 are adjacent to each other. In some other embodiments of this application, the sensor chip 61 may be further disposed between two adjacent light emitting chips 301. In this way, the sensor 60 does not need to be disposed in an independent area, and an effective display area of the display screen 10 can be increased.

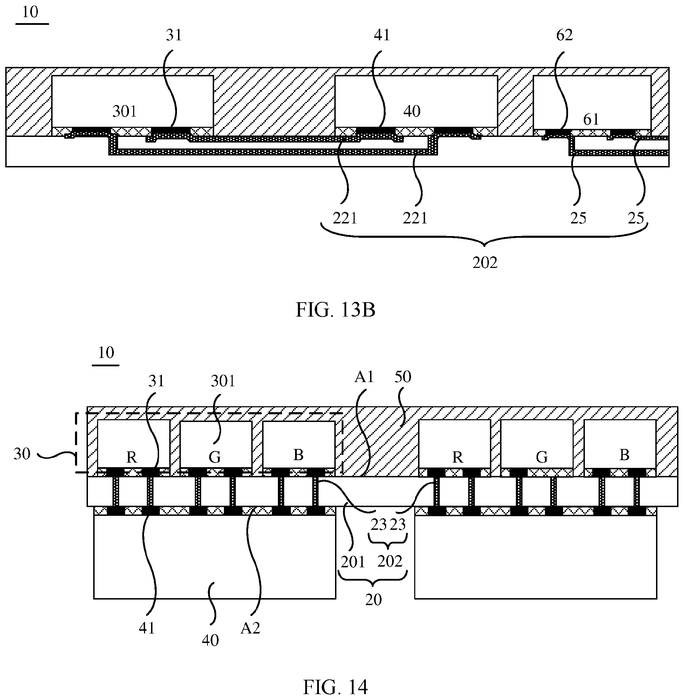

As shown in FIG. 13B, the pad 62 of the sensor chip 61 may be electrically connected to the metal interconnection structure 202. In addition, as shown in FIG. 13A, the display screen 10 further includes a plurality of second bonding pins 12b disposed in the second area 601. In this case, as shown in FIG. 13B, the metal interconnection structure 202 may further include a plurality of third metal wires 25. One end of the third metal wire 25 is electrically connected to the pad 62 of the sensor chip 61, and the other end of the third metal wire 25 is electrically connected to the second bonding pin 12b (as shown in FIG. 13A). In this way, after the second bonding pin 12b is welded to the bonding pin 12 of the circuit board 11, the sensor chip 61 may be electrically connected to the data processing chip 13 and the storage chip on the circuit board 11 through the third metal wire 25, so that the sensor 60 works under control of the data processing chip 13.

Similarly, when the first metal wire 221 is manufactured in the foregoing electroplating process, the third metal wire 25 may be manufactured at the same time, and the third metal wire 25 and the first metal wire 221 are spaced, to ensure that the third metal wire 25 is insulated from the first metal wire 221. In this case, the first metal wire 221 and the third metal wire 25 are on a same metal pattern layer. Alternatively, the first metal wire 221 and the third metal wire 25 may be separately manufactured in two electroplating processes. In this case, the first metal wire 221 and the third metal wire 25 may be on different metal pattern layers. The second metal wire 24 and the third metal wire 25 are insulated from each other. A disposing manner is the same as that described above, and details are not described herein again.

It should be noted that FIG. 13A is described by using an example in which the sensor 60, the driver chip 40, and the light emitting chip 301 are located on a surface of a same side of the redistribution layer 20. In this case, the sensor 60 is located on a display side of the display screen 10. Therefore, the sensor 60 may collect user-related data on the display side of the display screen 10, for example, sense a fingerprint, a facial feature, touch pressure, and the like of the user. In this case, the sensor 60 may be a fingerprint sensor, a pressure sensor, or a structured light sensor. Alternatively, in some other embodiments of this application, when the sensor 60 does not need to collect user-related data on the display side of the display screen 10. For example, when the sensor 60 is a temperature sensor, the sensor 60 may be disposed on a surface of a side that is of the redistribution layer 20 and that is away from the light emitting chip 301.

The foregoing description is provided by using an example in which both the light emitting unit 30 and the driver chip 40 in the display screen 10 are disposed on a same surface of the redistribution layer 20, and the light emitting unit 30 and the driver chip 40 are electrically connected through the metal pattern layer in the flexible dielectric layer 201. In some other embodiments of this application, as shown in FIG. 14, the light emitting chip 301 may be disposed on the first surface A1 of the redistribution layer 20, and the driver chip 40 is disposed on the second surface A2 of the redistribution layer 20. The first surface A1 and the second surface A2 are opposite to each other.

In this case, the metal interconnection structure 202 in the redistribution layer 20 may include at least one metal through via 23 that penetrates the flexible dielectric layer 201. One end of the metal through via 23 is bonded to the pad 31 of the light emitting chip 301, and the other end of the metal through via 23 is bonded to the pad 41 of the driver chip 40, so that the driver chip 40 can be electrically connected to the light emitting chip 301 by the metal through via 23. FIG. 14 is described by using an example in which the driver chip 40 is electrically connected to light emitting chips 301 configured to emit R light, G light, and B light respectively in the same light emitting unit 30.

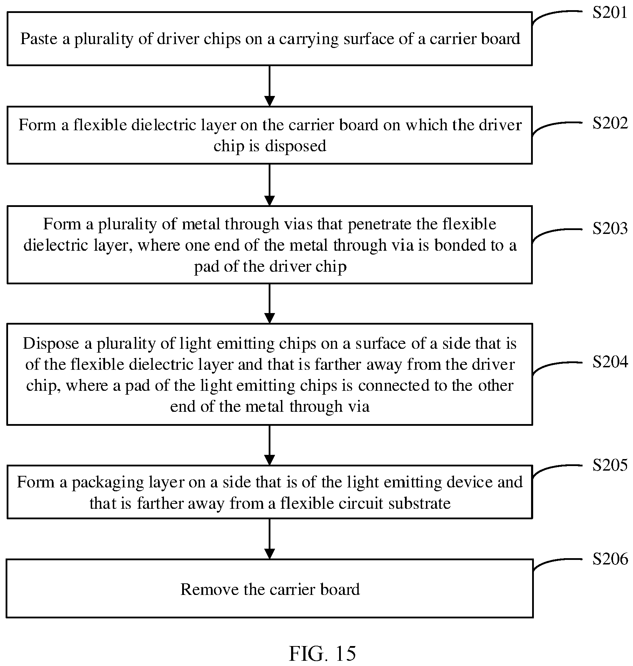

The method for manufacturing the structure shown in FIG. 14 may include S201 to S206 shown in FIG. 15.

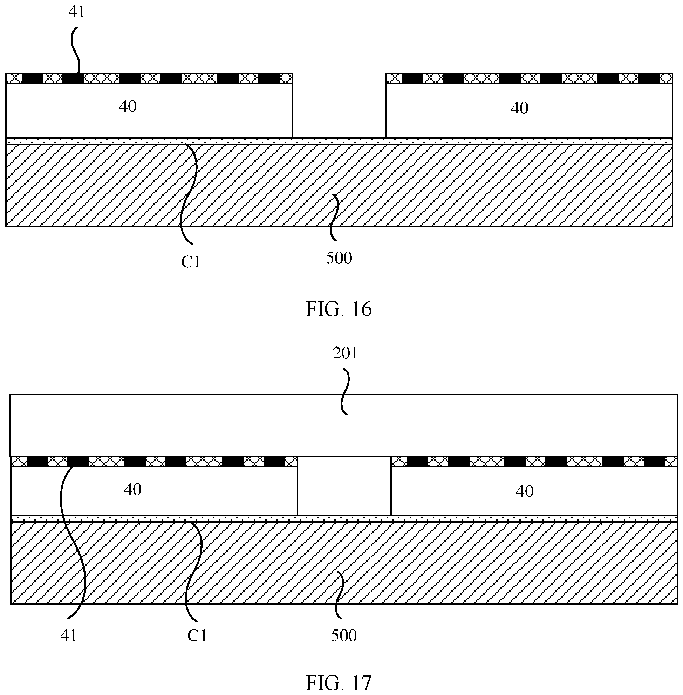

S201: Paste a plurality of driver chips 40 on the carrying surface C1 of the carrier board 500 as shown in FIG. 16.

For example, the passive surface of the driver chip 40 may be pasted onto the carrying surface C1 of the carrier board 500 by using thermal release adhesive, so that the carrying surface C1 of the carrier board 500 is away from the pad 41 of the driver chip 40.

S202: Form the flexible dielectric layer 201 on the carrier board 500 on which the driver chip 40 is disposed as shown in FIG. 17.

For example, a thin PI film may be used to cover the carrier board 500 on which the driver chip 40 is disposed, to form the flexible dielectric layer 201.

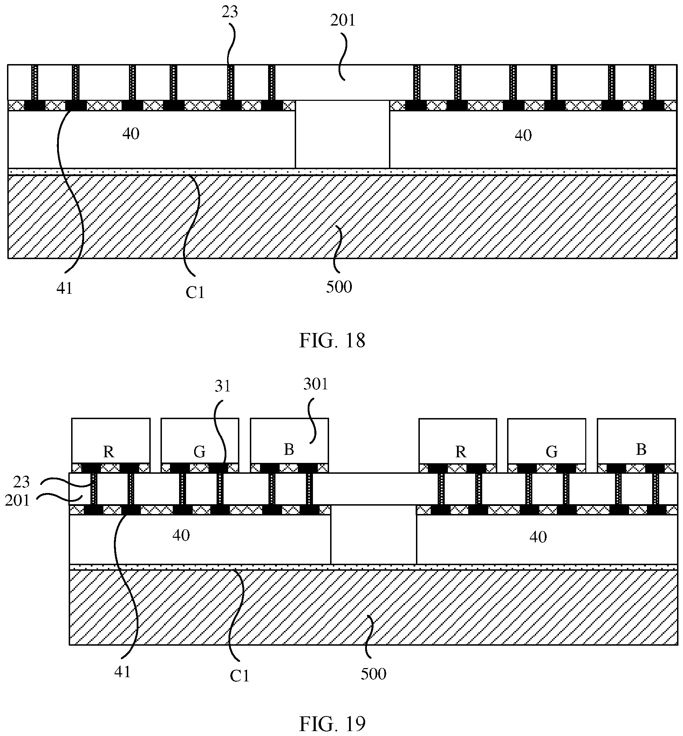

S203: Form a plurality of metal through vias 23 that penetrate the flexible dielectric layer 201, where one end (lower end) of the metal through via 23 is bonded to the pad 41 of the driver chip 40 as shown in FIG. 18.

For example, a through via (not shown in the figure) that penetrates the flexible dielectric layer 201 may be manufactured on the flexible dielectric layer 201 through photo etching. A metal material, for example, copper, is electroplated in the through via to form the metal through via 23. Photo etching may refer to forming a pattern by using a photoresist, a mask template, an exposure machine, or the like in a process such as film forming, exposure, and development.

In addition, before the plurality of metal through vias 23 are formed at the flexible dielectric layer 201, the second metal wire 24 (as shown in FIG. 12) may be formed at the flexible dielectric layer 201, so that the driver chip 40 can be electrically connected to the data processing chip 13 and the storage chip on the circuit board 11 by using the second metal wire 24.

S204: Dispose the plurality of light emitting chips 301 on a surface of a side that is of the flexible dielectric layer 201 and that is away from the driver chip 40, where the pad 31 of the light emitting chip 301 is connected to the other end (an upper end) of the metal through via 23 as shown in FIG. 19.

For example, the metal through via 23 may be bonded to the pad 31 of the light emitting chip 301 through metal bonding, so that the driver chip 40 can be electrically connected to the at least one light emitting chip 301 by using the metal through via 23.

S205: Form the packaging layer 50 shown in FIG. 14 on a side that is of the light emitting device 301 and that is away from the redistribution layer 20.

S206: Remove the carrier board 500 shown in FIG. 19.

For example, the thermal release adhesive used to bond the carrier board 500 and the driver chip 40 is heated to remove stickiness of the thermal release adhesive, to peel off the carrier board 500 to form the structure shown in 12.

Because the light emitting chip 301 and the driver chip 40 are respectively located on two opposite surfaces (the first surface A1 and the second surface A2) of the redistribution layer 20, the packaging layer 50 located on the side that is of the light emitting device 301 and that is away from the redistribution layer 20 covers the light emitting chip 301 and is connected to the redistribution layer 20. In this case, closed space for accommodating the light emitting chip 301 may be formed between the packaging layer 50 and the redistribution layer 20, so that the light emitting chip 301 can be isolated from an external environment of the display screen 10. A material of the packaging layer 50 is the same as that described above, and details are not described herein again.

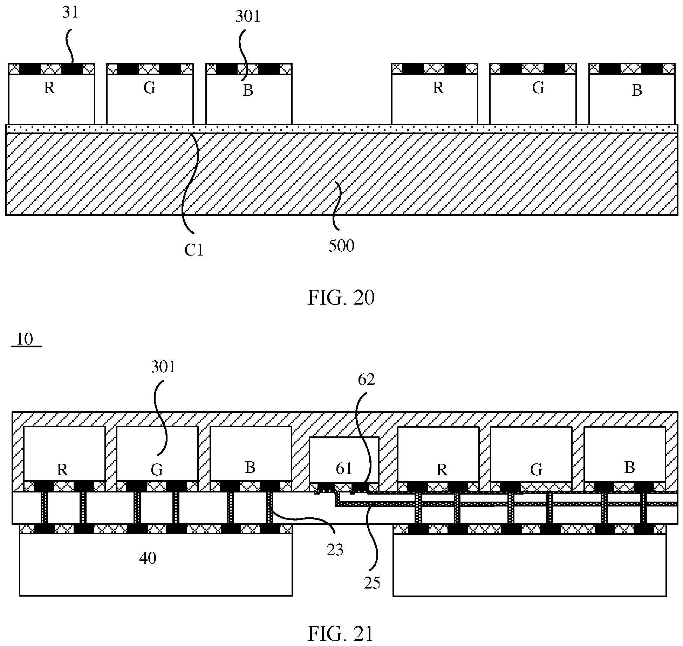

The foregoing is described by using an example in which the driver chip 40 is first disposed on the carrier board 500 shown in FIG. 15 in a process of manufacturing the structure shown in FIG. 14. In some other embodiments of this application, as shown in FIG. 20, the light emitting surface of the light emitting chip 301 may be first pasted to the carrier board 500 by using thermal release adhesive, and then a PI film is formed on the side on which the pad 31 of the light emitting chip 301 is located, and is used as the flexible dielectric layer 201. The metal through via 23 that penetrates the flexible dielectric layer 201 is formed in the flexible dielectric layer 201 through photo etching and electroplating. One end of the metal through via 23 is bonded to the pad 31 of the light emitting chip 301. On the surface of the side that is of the flexible dielectric layer 201 and that is away from the light emitting chip 301, the pad 41 of the driver chip 40 is bonded to the side that is of the metal through via 23 and that is away from the light emitting chip 301 in the metal bonding process, so that the driver chip 40 can be electrically connected to at least one light emitting chip 301 by using the metal through via 23. Finally, the carrier board 500 is removed and the packaging layer 50 covering the light emitting surface of the light emitting chip 301 is formed.

It can be learned from the foregoing description that, in the display screen 10 shown in FIG. 14, the light emitting chip 301 and the driver chip 40 are respectively disposed on the first surface A1 and the second surface A2 that are oppositely disposed at the redistribution layer 20, and the driver chip 40 is electrically connected by using the metal through via 23 that penetrates the flexible dielectric layer 201 at the redistribution layer 20. Similarly, the light emitting chip 301 is made of an inorganic material and has low sensitivity to water and oxygen. The light emitting chip 301 may be simply packaged by using a polymer material with good elasticity and high transparency. This improves bending reliability of the flexible display screen. In addition, when the display screen 10 is stretched and bent, a pulling force between the plurality of the light emitting chips 301 distributed in the discrete array is small. In addition, the flexible dielectric layer 201 at the redistribution layer 20 has good bendability and elasticity, and when the metal through via 23 that penetrates the flexible dielectric layer 201 at the redistribution layer 20 is manufactured with metal copper having good ductility, the elasticity and bendability of the redistribution layer 20 can be further improved.

Based on the structure of the display screen 10 shown in FIG. 14, to further improve integration of the display screen 10, the sensor may be integrated into the display screen 10. In some embodiments of this application, when the sensor 60 needs to collect user-related data on a display side of the display screen 10, as shown in FIG. 21, the sensor chip 61 and the light emitting chip 301 in the sensor may be located on the same side. As described above, the pad 62 of the sensor chip 61 is electrically connected to the third metal wire 25. The third metal wire 25 is insulated from the metal through via 23.

For example, the sensor chip 61 may be located between two adjacent light emitting chips 301. Alternatively, all sensor chips 61 in the sensor 60 may be adjacent to each other. In some other embodiments of this application, when the sensor 60 does not need to collect the user-related data on the display side of the display screen 10, the sensor chip 61 and the driver chip 40 may be located on the same side.

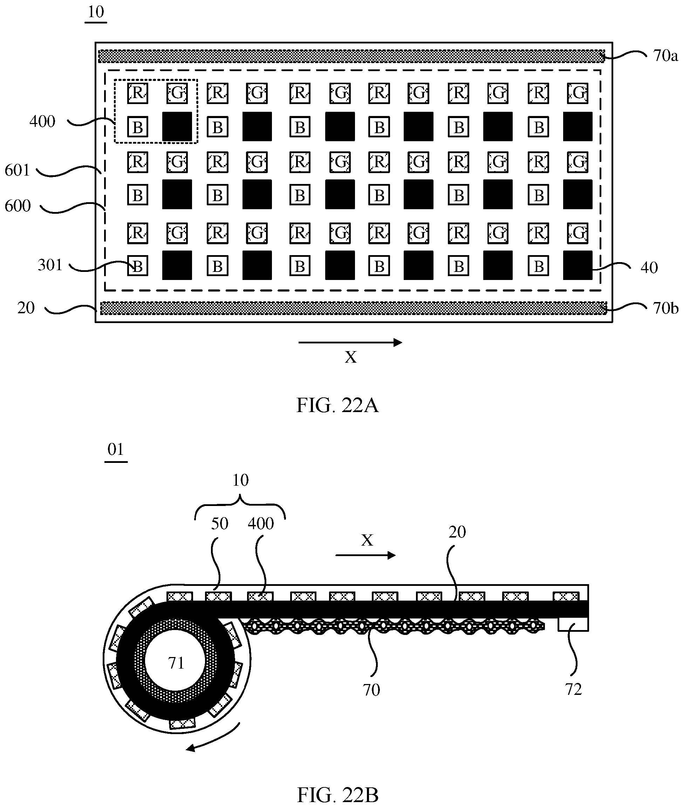

For ease of description, an example in which the light emitting chip 301 and the driver chip 40 are located on the same side of the redistribution layer 20 is used below for description. Based on this, to further improve bendability and elasticity of the display screen 10, the display screen 10 may include at least one flexible and stretchable layer disposed in the second area 601 shown in FIG. 22A. For example, a flexible and stretchable layer 70a is located above the first area 600 and a flexible and stretchable layer 70b is located below the first area 600. The flexible and stretchable layer 70a and the flexible and stretchable layer 70b are disposed in a stretching direction (an X direction) of the display screen 10. That is, the long side of the flexible and stretchable layer is parallel to the stretching direction (the X direction) of the display screen 10.

As shown in FIG. 22B, the flexible and stretchable layer 70 is connected to a surface of a side that is of the redistribution layer 20 and that is away from the minimum repetition unit 400 (including the light emitting chip 301 and the driver chip 40 that is electrically connected to the light emitting chip 301). The display terminal 01 may further include a reel 71. A part of the redistribution layer 20 and a part of the flexible and stretchable layer 70 are wound around the reel 71. An end that is of the redistribution layer 20 and wound around the reel 71 and an end that is of the flexible and stretchable layer 70 and wound around the reel 71 are connected to the reel 71.

In this way, when the display screen 10 is stretched in the stretching direction (the X direction) of the display screen 10, the reel 71 may rotate clockwise as shown in FIG. 22B, so that the part of the redistribution layer 20 and the part of the flexible and stretchable layer 70 that are wound around the reel 71 detach from the reel 71 and move in the X direction. In some embodiments of this application, an elastic modulus of the flexible and stretchable layer 70 may be larger than an elastic modulus of the flexible dielectric layer 201. In this case, a deformation of the flexible and stretchable layer 70 is smaller than a deformation of the flexible dielectric layer 201. Alternatively, in some other embodiments of this application, the elastic modulus of the flexible and stretchable layer 70 may be smaller than an elastic modulus of the flexible dielectric layer 201. In this case, when the display screen 10 is stretched in the stretching direction (the X direction) of the display screen 10, a deformation of the flexible and stretchable layer 70 is larger than a deformation of the flexible dielectric layer 201. Therefore, when the display screen 10 is stretched, the flexible and stretchable layer 70 can be easily stretched compared with the flexible dielectric layer 201. In this way, excessive stretching of the flexible dielectric layer 201 can be avoided, to prevent damage to the metal interconnection structure inside the flexible dielectric layer 201 and to the light emitting unit 30 and the driver chip 40 that are at the flexible dielectric layer 201.

Because one end that is of the redistribution layer 20 and wound around the reel 71 and one end that is of the flexible and stretchable layer 70 and wound around the reel 71 are connected to the reel 71, after the display screen 10 is completely stretched, one end of the display screen 10 may be fastened to the reel 71 by using the redistribution layer 20 and the flexible and stretchable layer 70. In addition, a position-fixing component 72 may be disposed at an end that is of the display screen 10 and that is away from the reel 71. The user can fix a position of the stretched display screen 10 by clamping the position-fixing component 72 into a housing (not shown in the figure) of the display terminal 01to.

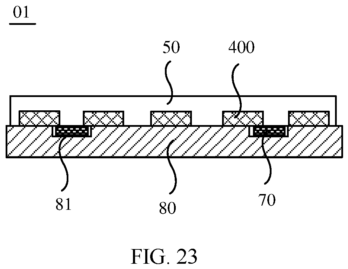

In addition, as shown in FIG. 23, a guide groove 81 matching the flexible and stretchable layer 70 may be disposed on the housing 80 of the display terminal 01. When the display screen 10 is pulled out from the reel 71 shown in FIG. 22B, the flexible and stretchable layer 70 of the display screen 10 may slide into the guide groove 81, so that a surface of a side that is of the flexible and stretchable layer 70 and that is away from the minimum repetition unit 400 may contact a bottom of the guide groove 81 and move in a stretching direction of the guide groove 81 in a stretching process. In this way, in the stretching process, the display screen 10 may move in the stretching direction of the guide groove 81, thereby reducing a probability that position deviation of the display screen 10 occurs in the stretching process.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display screen, comprising:
a redistribution layer, comprising a flexible dielectric layer and a metal interconnection structure disposed in the flexible dielectric layer;
a plurality of light emitting units, wherein the light emitting unit comprises at least one light emitting chip, the light emitting chip is disposed on the redistribution layer, and a pad of the light emitting chip is bonded to the metal interconnection structure; and
a plurality of driver chips, disposed on the redistribution layer, wherein a pad of the driver chip is bonded to the metal interconnection structure, one driver chip is electrically connected to the light emitting chip in the same light emitting unit by using the metal interconnection structure, and the driver chip is configured to drive the light emitting chip to emit light.

2. The display screen according to claim 1, wherein
the redistribution layer comprises a first surface, and both the light emitting chip and the driver chip are disposed on the first surface; and
the metal interconnection structure comprises a metal pattern layer, wherein a side that is of the metal pattern layer and that is away from the light emitting chip is in contact with the flexible dielectric layer, the metal pattern layer comprises a plurality of first metal wires, one end of the first metal wire is bonded to the pad of the light emitting chip, and the other end of the first metal wire is bonded to the pad of the driver chip.

3. The display screen according to claim 1, wherein
the redistribution layer comprises a first surface and a second surface, the first surface and the second surface are disposed opposite to each other, the light emitting chip is disposed on the first surface, and the driver chip is disposed on the second surface; and
the metal interconnection structure comprises a metal through via that penetrates the flexible dielectric layer, wherein one end of the metal through via is bonded to the pad of the light emitting chip, and the other end of the metal through via is bonded to the pad of the driver chip.

4. The display screen according to claim 2 or 3, wherein a material of the metal interconnection structure is the same as a material of the pad of the light emitting chip and a material of the pad of the driver chip.

5. The display screen according to claim 1, wherein the display screen has a first area and a second area located around the first area, and the light emitting unit and the driver chip are located in the first area;
the display screen further comprises a plurality of first bonding pins disposed in the second area; and
the metal interconnection structure comprises a metal pattern layer, wherein a side that is of the metal pattern layer and that is away from the light emitting chip is in contact with the flexible dielectric layer, the metal pattern layer comprises a plurality of second metal wires, one end of the second metal wire is electrically connected to the pad of the driver chip, and the other end of the second metal wire is electrically connected to the first bonding pin.

6. The display screen according to any one of claims 1 to 5, wherein
the display screen further comprises a sensor, the sensor comprises a sensor chip, the sensor chip is disposed on the redistribution layer, and a pad of the sensor chip is electrically connected to the metal interconnection structure.

7. The display screen according to claim 6, wherein the sensor chip and the light emitting chip are located on a same side, and are disposed between two adjacent light emitting chips.

8. The display screen according to claim 7, wherein the display screen has the first area and the second area located around the first area, and the light emitting unit and the driver chip are located in the first area;
the display screen further comprises a plurality of second bonding pins disposed in the second area; and
the metal interconnection structure comprises the metal pattern layer, wherein a side that is of the metal pattern layer and that is away from the light emitting chip is in contact with the flexible dielectric layer, the metal pattern layer comprises a plurality of third metal wires, one end of the third metal wire is electrically connected to the pad of the sensor chip, and the other end of the third metal wire is electrically connected to the second bonding pin.

9. The display screen according to any one of claims 1 to 8, wherein
the at least one light emitting chip in the same light emitting unit comprises a first light emitting chip, a second light emitting chip, and a third light emitting chip, wherein the first light emitting chip, the second light emitting chip, and the third light emitting chip respectively are configured to emit trichromatic light; and
one driver chip is electrically connected to the first light emitting chip, the second light emitting chip, and the third light emitting chip in the same light emitting unit.

10. The display screen according to any one of claims 1 to 8, wherein
the display screen has the first area and the second area located around the first area, and the light emitting unit and the driver chip are located in the first area; and
the display screen further comprises a flexible and stretchable layer, wherein the flexible and stretchable layer is disposed in the second area in a stretching direction of the display screen, and is connected to a surface of a side that is of the redistribution layer and that is away from the light emitting unit.

11. The display screen according to any one of claims 1 to 10, wherein the display screen further comprises:
a packaging layer, located on a side that is of the light emitting chip and that is away from the redistribution layer, and covering the light emitting chip and the redistribution layer.

12. The display screen according to claim 11, wherein a material of the packaging layer comprises silica gel.

13. The display screen according to claim 1, wherein a material of the flexible dielectric layer comprises polyimide.

14. A display terminal, comprising a circuit board and the display screen according to any one of claims 1 to 13, wherein the circuit board is electrically connected to a metal interconnection structure in a redistribution layer.

15. The display terminal according to claim 14, wherein the display screen has a first area and a second area located around the first area; a light emitting unit and a driver chip are located in the first area; the display screen further comprises a flexible and stretchable layer; and the flexible and stretchable layer is disposed in the second area in a stretching direction of the display screen, and is connected to a surface of a side that is of the redistribution layer and that is away from the light emitting unit; and
the display terminal further comprises a reel, a part of the redistribution layer and a part of a flexible and stretchable layer are wound around the reel, and the reel is connected to an end that is of the redistribution layer and wound around the reel and an end that is of the flexible and stretchable layer and wound around the reel.

16. The display terminal according to claim 14, wherein the circuit board is a flexible circuit board.

17. A method for manufacturing a display screen, comprising:
pasting a plurality of light emitting chips and a plurality of driver chips to a carrying surface of a carrier board, wherein a pad of the light emitting chip and a pad of the driver chip are far away from the carrying surface of the carrier board;
forming a plurality of first metal wires on the carrier board on which the light emitting chip and the driver chip are disposed, bonding one end of the first metal wire to the pad of the light emitting chip, and bonding the other end of the first metal wire to the pad of the driver chip;
forming a flexible dielectric layer on a surface of a side that is of the first metal wire and that is away from the carrier board; and
removing the carrier board.

18. The manufacturing method according to claim 17, wherein the method further comprises:
forming, on a surface of a side that is of plurality of light emitting chips and the plurality of driver chips and that is away from the flexible dielectric layer, a packaging layer that covers the plurality of light emitting chips, the plurality of driver chips, and the flexible dielectric layer.

19. A method for manufacturing a display screen, comprising:
pasting a plurality of driver chips to a carrying surface of a carrier board, wherein a pad of the driver chip is far away from the carrying surface of the carrier board;
forming a flexible dielectric layer on the carrier board on which the driver chip is disposed;
forming a plurality of metal through vias that penetrate the flexible dielectric layer, wherein one end of the metal through via is bonded to the pad of the driver chip;
disposing a plurality of light emitting chips on a surface of a side that is of the flexible dielectric layer and that is away from the driver chip, wherein a pad of the light emitting chip is connected to the other end of the metal through via, so that one driver chip is electrically connected to at least one light emitting chip; and
removing the carrier board.

20. The manufacturing method according to claim 19, wherein the method further comprises:
forming, on a surface of a side that is of the plurality of light emitting chips and that is away from the flexible dielectric layer, a packaging layer that covers the plurality of light emitting chips and the flexible dielectric layer.
